Europäisches Patentamt

European Patent Office

Office européen des brevets

(11) Publication number : **0 469 840 A2**

# (12) EUROPEAN PATENT APPLICATION

(21) Application number : **91306949.8**

(22) Date of filing : **29.07.91**

(51) Int. Cl.⁵ : **H01L 21/82, H01L 21/76**

(30) Priority : **30.07.90 US 559777**

(43) Date of publication of application :
**05.02.92 Bulletin 92/06**

(84) Designated Contracting States :
**DE FR**

(71) Applicant : **Nippon Motorola Ltd.**
**3-20-1 Minami-Azabu Minato-ku**
**Tokyo 106 (JP)**

(72) Inventor : **Sakamoto, Hiroshi**
**4-18-17 Hirado, Totsuka-ku**
**Yokohama, Kanagawa (JP)**

(74) Representative : **Lupton, Frederick et al**
**Motorola European Intellectual Property**
**Operations Seal House Seal Road**
**Basingstoke, Hants RG21 1NQ (GB)**

(54) Transistor with predetermined emitter area and method of manufacturing.

(57)    A bipolar transistor (30) with an exact predetermined emitter electrode area (50) and a method of manufacturing the transistor on a C-MOS substrate (34) and during the C-MOS manufacturing process without additional process steps. The normal C-MOS gate oxide producing steps are used to form a masking layer (46) to define the emitter electrode area (50).

FIG. 5

EP 0 469 840 A2

The present invention pertains to a bipolar transistor with a predetermined emitter electrode area and method of manufacturing and more specifically to the production of bipolar transistors with predetermined emitter electrode areas during a C-MOS manufacturing process.

## Background of the Invention

In many instances, especially for power circuits, voltage references and voltage regulators, it is desirable to include bipolar transistors with very specific emitter current characteristics. The emitter current of a bipolar transistor is determined by the size of the emitter electrode area. Also, bipolar transistors may be manufactured with or included in other processes, such as a C-MOS process. In these instances, the bipolar transistors are formed with the normal process steps, producing the transistors almost as a bonus.

The problem is that size of the area of the emitter electrode in a bipolar transistor is actually determined by resultant factors of the field oxidation process and a spreading mode of diffusion. The finished or final boundary of a field oxidation process, generally referred to as a "bird's beak", is not uniform, so that the area of the emitter electrode of a bipolar transistor is not uniform. It is, therefore, very difficult to control or predict the final area of the emitter electrode.

## Summary of the Present Invention

It is an object of the present invention to provide a new and improved bipolar transistor with a predetermined emitter electrode area and method of manufacturing the transistor.

It is a further object of the present invention to provide a method of manufacturing a bipolar transistor with a predetermined emitter electrode area during a C-MOS manufacturing process.

It is a further object of the present invention to provide a bipolar transistor with improved beta and resistance to radiation and the leakage caused thereby and reduced noise.

The above and other objects are realized in a method of forming a bipolar transistor with a predetermined emitter electrode area on a semiconductor substrate including the steps of forming a well of a second conductivity type in a substrate of a first conductivity type, forming a field oxide layer at the surface of the well and substrate to define a general emitter electrode area, forming a layer of masking material within the field oxide layer on the surface of the general emitter electrode area, said layer of masking material defining a predetermined emitter area within the general emitter area, and diffusing an impurity material into the predetermined emitter electrode area to form an emitter electrode with a predetermined area of the first conductivity type.

The above and other objects are further realized in the bipolar transistor manufactured in accordance with the above method and in bipolar transistors with a predetermined emitter electrode area manufactured during a C-MOS manufacturing process.

## Brief Description of the Drawings

Referring to the drawings:
FIG.1 is a view in top plan of a prior art bipolar transistor formed in a semiconductor substrate;
FIG.2 is a sectional view as seen from the line 2-2 in FIG.1;
FIG.3A and 3B are sectional views illustrating small portions of prior art bipolar transistors for comparative purposes;
FIG.4 is a view in top plan of a bipolar transistor embodying the present invention; and
FIG.5 is a sectional view as seen from the line 5-5 in FIG.4.

## Description of the Problem

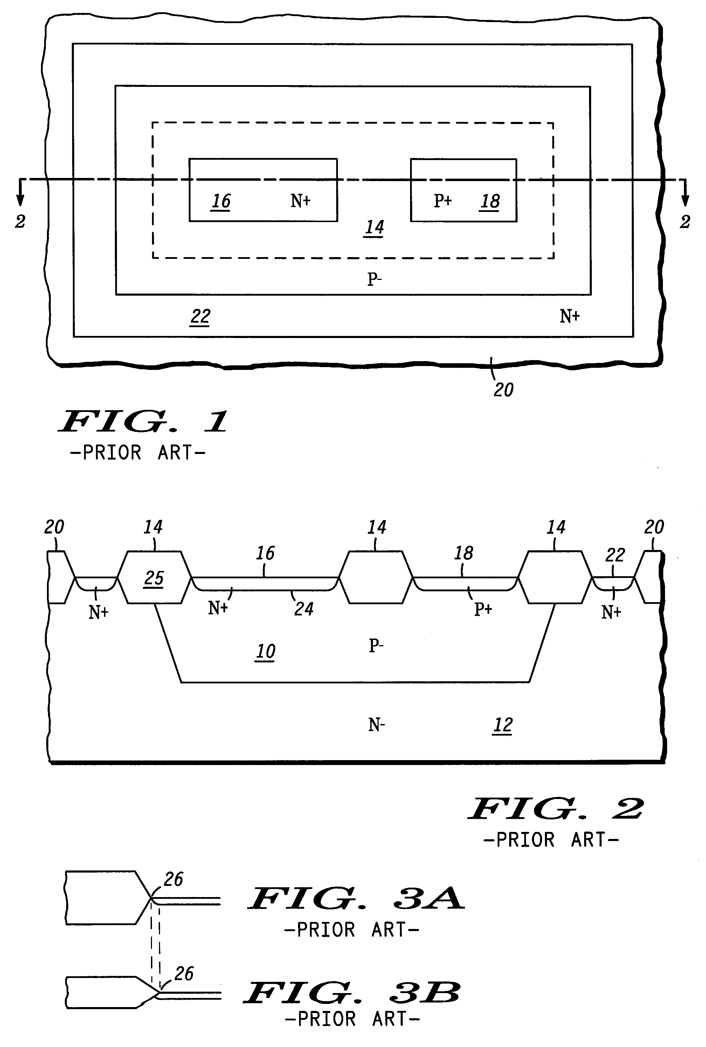

Referring specifically to FIGS.1 and 2, a bipolar transistor is illustrated which is manufactured in accordance with the prior art methods. In this process a $P^-$ well 10 is formed in a semiconductor substrate 12 with an $N^-$ type of conductivity. Field oxide layers 14 are formed to define an emitter electrode area 16 and a base contact area 18. Another field oxide layer 20 is formed around the well 10 to define a collector contact area 22. An impurity is diffused into the emitter electrode area 16 to form the N+ diffusion 24 which is the emitter electrode.

The problem with the bipolar transistor described in FIGS.1 and 2 is that the field oxide layer 14 determines the area of the N+ diffusion 24 and, hence, the emitter electrode area. Because of the manner in which field oxide layers form, or are grown, relatively sharp edges 26 (see FIG.3) of the oxide layer form at the surface of the substrate, which sharp edges are referred to as a "bird's beak". The length of the "bird's beak" is determined by the rate of growth of the oxide, the thickness of the oxide and many other variables. Also, as illustrated in FIGS. 3A and 3B, the diffusion of the N+ impurity into substrate 12 is controlled by the length of the "bird's beak". As can be seen in FIG.3, diffusion extends substantially farther under the sharper "bird's beak" illustrated in FIG.3B than the diffusion extends under the "bird's beak" illustrated in FIG.3A. This difference in diffusion produces a substantial difference in the final area of the emitter electrode and causes a substantial difference in emitter current between the two bipolar transistors. Further, because of the number and type of variables that effect the shape of the "bird's beak", it is extremely difficult to produce a bipolar transistor with a predetermined emitter electrode area.

## Description of the Preferred Embodiment

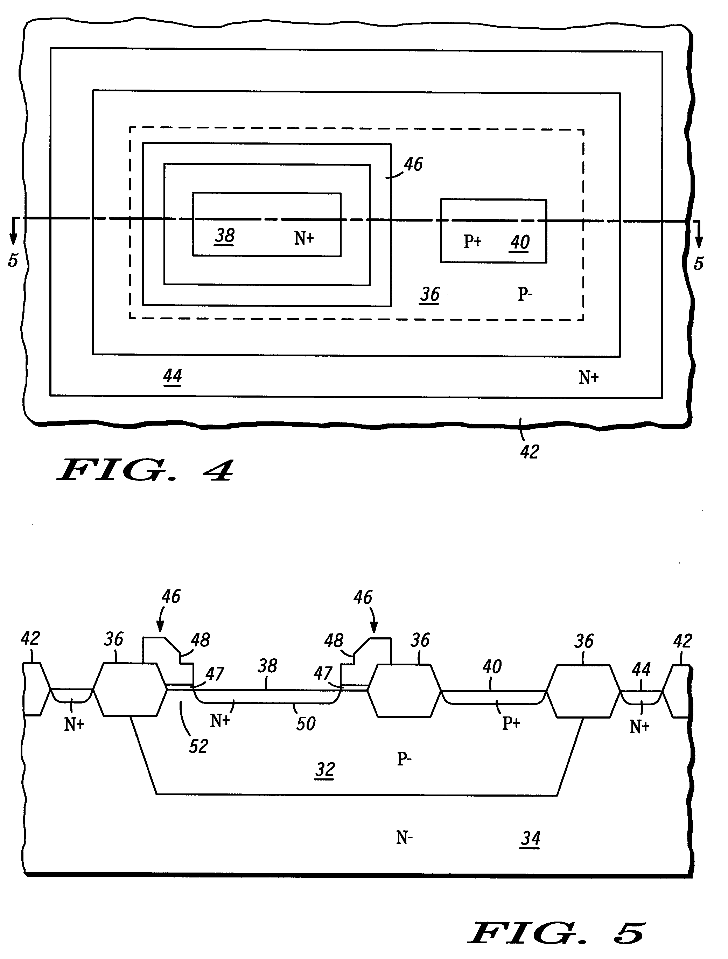

Referring specifically to FIGS.4 and 5, a bipolar transistor 30 embodying the present invention is illustrated. Transistor 30 is formed on a substrate 34, having a first type of conductivity, for example N⁻ type, generally as follows. A well 32 with a second type of conductivity, for example P⁻, is formed in substrate 34. A field oxide layer 36 is formed on the surface of well 32 and substrate 34 to define a general emitter electrode area 38 and a base electrode contact area 40. Another layer of field oxide 42 is formed around well 32 to define a collector electrode contact area 44. A layer, or layers, of material 46, which forms a masking layer, is deposited or grown in the general emitter electrode area 38 and etched to form an exact predetermined area for the diffusion of the emitter electrode. An impurity is diffused into the predetermined emitter electrode area to form an emitter electrode 50 having a conductivity type similar to the first type, in this example N+. Since the etching of masking layer 46 can be controlled very precisely and since the edges of the masking layer are very uniform, the diffusion is completely controlled and the emitter electrode area is exactly the predetermined area.

In the present embodiment, substrate 34 is a C-MOS substrate utilized in a C-MOS manufacturing process to produce a C-MOS chip. In general the various steps described in conjunction with the production of bipolar transistor 30 are steps utilized in the C-MOS manufacturing process. In effect, bipolar transistor 30 is simply a by-product of the C-MOS manufacturing process. As such, masking layer 46 can be most easily and efficiently produced as a silicon dioxide and/or a polysilicon layer. In the present embodiment, a silicon dioxide layer 47, which is used in the C-MOS manufacturing process as a gate oxide, is deposited in the general emitter electrode area 38 on the surface of well 32. A layer 48 of polysilicon is grown on the upper surface of layer 47 with the layers being masked and etched during the normal C-MOS process to form the final composite layer 46 illustrated in FIG.5. The growth, masking and subsequent etching to form gate insulators and polysilicon gates is very closely controlled in the C-MOS process so that an extremely accurate emitter area is produced. Growing, masking and etching of polysilicon and/or silicon dioxide layers are common steps in the normal C-MOS manufacturing process and, therefore, the present process is completely compatible with the C-MOS manufacturing process.

In addition to the advantage of obtaining a bipolar transistor with very precise emitter electrode area and, therefore, a very precisely controlled emitter current, the present invention provides a bipolar transistor with an increased $H_{fe}$ (beta). While the exact reason for this phenomenon is not known, it is believed that it involves the surface texture and recombination of carriers. There is a tendency for carriers to recombine more readily at rough surfaces, thereby, reducing the $H_{fe}$ and increasing the noise. The surface near and under field oxides, which are generally very coarse, is very rough and irregular. Whereas, the surface near and under the finer polysilicon or silicon dioxides is much smoother. Therefore by diffusing the emitter electrode under the surface adjacent a polysilicon or silicon dioxide layer recombination is not increased and the $H_{fe}$ (beta) is increased and the noise is reduced.

An additional and unanticipated advantage is realized by the novel bipolar transistor described. In field oxide layers, such as layer 36, extreme and highly undesirable leakage currents can occur because of radiation breakdown. Such leakage occurs particularly in area 25 (see FIG.2) where the emitter electrode and the collector electrode are closest together. The leakage current travels through field oxide 14 under the influence of radiation, which produces carriers therein. This leakage effect is substantially reduced or eliminated by the extra spacing produced (see FIG.5 at 52) by including masking material 46.

Thus, a bipolar transistor with predetermined emitter electrode area is disclosed. Further, a method of manufacturing the improved bipolar transistor is described. In addition, the manufacture of the improved bipolar transistor as a portion, of a C-MOS manufacturing process in which no additional steps are added, is disclosed. The improved bipolar transistor may be used in circuits requiring critical emitter currents, such as voltage reference circuits, voltage regulators, etc., especially if these control circuits are produced in C-MOS type of circuits.

While I have shown and described specific embodiments of the present invention, further modifications and improvements will occur to those skilled in the art. I desire it to be understood, therefore, that this invention is not limited to the particular forms shown and I intend in the appended claims to cover all modifications which do not depart from the spirit and scope of this invention.

## Claims

**#1** A method of forming a bipolar transistor (30) with a predetermined emitter electrode area on a semiconductor substrate comprising the steps of

providing a semiconductor substrate (34) of a first conductivity type,

forming a well (32) of a second conductivity type in the semiconductor substrate (34), and

forming at least a field oxide layer (36) at the surface of the well (32) and substrate (34) to define a general emitter electrode area (38) for a bipolar transistor (30), the method being characterized by the further steps of

forming a layer of masking material (46) within the field oxide layer (36) on the surface of the general emitter electrode area (38), said layer of masking material (46) defining a predetermined emitter electrode area (50) within the general emitter electrode (38) and

diffusing material into the exact predetermined emitter electrode area (50) to form an emitter electrode (50) with a predetermined area of the first conductivity type.

**#2** A method of forming a bipolar transistor (30) with a predetermined emitter electrode area during a C-MOS manufacturing process comprising the steps of

providing a C-MOS semiconductor substrate (34) having a first conductivity type,

forming a well (32) of a second conductivity type in the C-MOS semiconductor substrate (34), and

forming at least a field oxide layer (36) at the surface of the well (32) and substrate (34) to define a general emitter electrode area (38) for a bipolar transistor (30), the method being characterized by the additional steps of

growing a layer of silicon dioxide material (46) within the field oxide layer (36) on the surface of the general emitter electrode area (38) and etching said layer of silicon dioxide material (36) to define a predetermined emitter electrode area (50) within the general emitter electrode area (38) and

diffusing material into the predetermined emitter electrode area (50) to form an emitter electrode (50) having a predetermined area of the first conductivity type.

**#3** A method of forming a bipolar transistor (30) with a predetermined emitter electrode area during a C-MOS manufacturing process as claimed in claim 2 further characterized in that the step of growing a layer of silicon dioxide material (46) coincides with a step of growing a layer of silicon dioxide in the C-MOS process.

**#4** A bipolar transistor (30) with a predetermined emitter electrode area on a C-MOS semiconductor substrate (34) comprising

a C-MOS substrate (34) having a first conductivity type,

a well (32) in said substrate (34) having a second conductivity type, and

field oxide layers (36 and 42) at the surface of said well (32) and substrate (34) defining general emitter electrode (38) and base (40) and collector (44) contact areas, the bipolar transistor being characterized by

a silicon dioxide layer (46) on the surface of the general emitter electrode area (38), said silicon dioxide layer (46) defining a predetermined emitter area (50) within the general emitter electrode area (38) and

material diffused into said predetermined emitter area (50) to form an emitter electrode (50) with a predetermined area.

**#5** A bipolar transistor (30) with a predetermined emitter electrode area comprising

a substrate (34) having a first conductivity type,

a well (32) in said substrate (34) having a second conductivity type, and

a field oxide layer (36) at the surface of said well (32) and substrate (34) defining a general emitter electrode area (38), the bipolar transistor being characterized by

a layer of masking material (46) on the surface of the general emitter electrode area (38), said layer (46) defining a predetermined emitter electrode area (50) within the general emitter electrode area (38) and

impurity material diffused into said predetermined emitter electrode area (50) to form an emitter electrode (50) of the first conductivity type with a predetermined area.

4

FIG. 1

-PRIOR ART-

FIG. 2

-PRIOR ART-

FIG. 3A

-PRIOR ART-

FIG. 3B

-PRIOR ART-

FIG. 4

FIG. 5